# EUROPÄISCHE PATENTSCHRIFT

(11) **EP 1 492 977 B1**
(45) Veröffentlichungstag und Bekanntmachung des Hinweises auf die Patenterteilung: **07.12.2005**
(21) Anmeldenummer: 03750406.5
(22) Anmeldetag: 31.07.2003
(51) Int. Cl.: F16L 21/06, H03K 17/95

(54) **BEFESTIGUNGSSOCKEL ZUM HALTERN EINES ELECTRISCHEN GER TS**
FASTENING BASE FOR MOUNTING AN ELECTRIC DEVICE
SOCLE DE FIXATION CONCU POUR ASSURER LE SUPPORT D'UN APPAREIL ELECTRIQUE

(30) Priorität: 24.01.2003 DE 20301144 U
(43) Veröffentlichungstag der Anmeldung: 05.01.2005
(73) Patentinhaber: Pepperl + Fuchs GmbH, 68307 Mannheim (DE)
(72) Erfinder: BERG, Eckhard, 67269 Grünstadt (DE)
(74) Vertreter: Heim, Hans-Karl
(86) Internationale Anmeldenummer: PCT/EP2003/008494
(87) Internationale Veröffentlichungsnummer: WO 2004/065836

(56) Entgegenhaltungen:
- DE-A- 19 920 771
- DE-C- 19 900 876
- US-A- 4 704 524

## Beschreibung

Die Erfindung betrifft einen Befestigungssockel zum Haltern eines elektrischen Geräts, insbesondere eines elektrischen Sensors oder eines elektrischen Näherungsschalters, mit einer Aufnahmeöffnung zur Aufnahme eines Anschlussstutzens des elektrischen Geräts und mit einem Verriegelungsschwenkhebel zum Fixieren des Anschlussstutzens in der Aufnahmeöffnung, wobei der Verriegelungsschwenkhebel in eine Verriegelungs- und eine Offenstellung verschwenkbar ist.

Die Erfindung betrifft ausserdem einen Befestigungssockel zum Haltern eines elektrischen Gerätes, wie elektrischer Sensor oder elektrischer Näherungsschalter, mit einer Aufnahmeöffnung des Befestigungssockels zur Aufnahme eines am elektrischen Gerät vorragenden, in die Aufnahmeöffnung passenden Anschlussstutzens, welcher eine peripher wenigstens teilweise umlaufende Aussparung aufweist, wobei der Befestigungssockel ein Klemmteil besitzt, welches zum Haltern des Gerätes innerhalb der Aufnahmeöffnung in die Aussparung des Anschlussstutzens in eine Verriegelungsstellung absenkbar und zum Lösen desselben aus der Aussparung des Anschlussstutzens in eine Offenstellung hebbar angeordnet ist.

Ein gattungsgemäßer Befestigungssockel ist in DE 199 00 876 C1 beschrieben. Um ein möglichst einfaches und schnelles Auswechseln und eine endgültige Fixierung eines Näherungsschalters zu erreichen, ohne dass Einzelteile verloren gehen können oder Werkzeuge zur Fixierung des Näherungsschalters notwendig sind, ist dort ein verschwenkbarer Klemmhebel vorgesehen. Zur Fixierung des Näherungsschalters ist an dem Klemmhebel ein Klemmelement mit einer wulstartigen Auswölbung vorgesehen, die mit dem Näherungsschalter in kraftschlüssigen Eingriff kommt.

Es sind elektrische Niederspannungsschaltgeräte für Gleichspannung in quaderförmiger Form mit quadratischem Querschnitt mit drei oder vier Anschlüssen, insbesondere induktive Näherungsschalter der Form C für Gleichspannung mit drei oder vier Anschlüssen gemäß der EN 60947-5-2, bekannt, welche genormte Maße einschließlich der Befestigungslöcher für Befestigungsmittel aufweisen. Bei einem bekannten derartigen induktiven Näherungsschalter sind zu seiner Verstellung bezüglich des Befestigungssockels wenigstens zwei Befestigungsschrauben zu lösen.

Durch die DE 41 15 253 C2 ist ein in verschiedenen Ansprechrichtungen ausrichtbarer elektronischer Näherungsschalter bekannt, der aus einem würfelförmigen Sensorgehäuse sowie aus einem an einer Gehäusekante des Sensorgehäuses wahlweise in zwei verschiedenen Wendelagen befestigbaren, einen Anschlussstutzen aufweisenden Wendewinkel und aus einem am Einbauort zu montierenden Sockelteil besteht, das mit einer Öffnung zur drehbaren Aufnahme des Anschlussstutzens des Wendewinkels versehen ist und an dem der Wendewinkel in vier, jeweils um 90 Grad unterschiedlichen Drehstellungen arretierbar ist. Das Sensorgehäuse enthält die gesamte Schaltungselektronik und das Sockelteil ist als reiner Montageblock ausgebildet, wobei innerhalb des mit vier radialen Durchgangsbohrungen versehenen Anschlussstutzens ein axial fixierter Stecker drehbar gelagert ist. Der Montageblock trägt eine Feststellschraube, die wahlweise durch eine der Durchgangsbohrungen hindurch bis Auftreffen auf den Stecker einschraubbar ist, so dass mittels der Feststellschraube die Drehstellung des Wendewinkels stufenweise und die Drehstellung des Steckers stufenlos am Montageblock dreharretiert sind.

Durch die DE 196 18 664 A1 ist eine Befestigungsvorrichtung zur Aufnahme eines Gehäuses, wie Näherungsschalter, bekannt geworden, welche Vorrichtung aus einem Befestigungssockel mit einer Aufnahmeöffnung besteht, innerhalb der das Gehäuse drehbar und arretierbar befestigt ist. Das Gehäuse weist einen Drehsockel auf, der einen Rohrflansch besitzt, der innerhalb der Aufnahmeöffnung des Befestigungssockels sitzt und an dem eine Schrägfläche angeordnet ist; ebenso weist der Befestigungssockel im Randbereich einer seiner Stirnflächen einen Aufnahmeraum auf, der die Aufnahmeöffnung anschneidet und in die die Schrägfläche des Rohrflansches ragt, wobei innerhalb des Aufnahmeraumes ein Klemmkeil beweglich angeordnet ist. Der Klemmkeil weist an einem Ende eine Durchgangsbohrung auf zum Durchgang einer der Befestigungsschrauben für den Befestigungssockel, wobei der Klemmkeil beim Festschrauben des Befestigungssockels mittels der den Klemmkeil halternden Befestigungsschraube auf der Schrägfläche des Drehsockels gleitet zum klemmenden Verspannen desselben innerhalb des Befestigungssockels. Auf diese Weise ist aufgrund der Verklemmung mittels Befestigungsschraube und Klemmkeil sowohl der Rohrflansch als auch die Steckeraufnahme innerhalb des Rohrflansches verklemmt, wie auch gleichzeitig das Gehäuse klemmend gehaltert ist. Aufgrund der Schrägflächen des Rohrflansches und des Klemmkeils ist beim Verklemmen auch eine geringe laterale Bewegung des Gehäuses gegeben, welche zur sicheren Verklemmung beiträgt. Nachteilig ist hier, dass zum Wechseln des Gehäuses bzw. des Sensors Schrauben gelöst werden müssen, wobei dadurch der Aufbau und die Gestaltung des Befestigungssockels kompliziert und dadurch teuer ist.

Weitere gattungsgemäßen Befestigungssockel sind aus DE 199 20 771 A und US 4 704 524 bekannt.

Der Erfindung liegt die Aufgabe zugrunde, einen Befestigungssockel zum Haltern eines elektrischen Gerätes, wie elektrischer Sensor oder elektrischer Näherungsschalter gemäß der genannten Gattung zu schaffen, welcher mit quasi einem Handgriff das Auswechseln des darin befestigten elektrischen Gerätes ohne weitere Hilfsmittel bzw. das Platzieren des elektrischen Gerätes in einer definierten Betriebslage gestattet.

Diese Aufgabe wird durch einen Befestigungssockel mit den Merkmalen des Patentanspruchs 1 gelöst.

Ein Befestigungssockel der oben angegebenen Art ist erfindungsgemäß dadurch weitergebildet, dass der Verriegelungsschwenkhebel einen vorstehenden Keil aufweist und dass der Keil zum wenigstens teilweise formschlüssigen Eingriff mit einer im Anschlussstutzen vorgesehenen Aussparung bei in Verriegelungsstellung geschwenktem Verriegelungsschwenkhebel ausgebildet ist.

Eine weitere Lösung der Aufgabe besteht in einem weiteren Aspekt der Erfindung darin, dass bei einem Befestigungssockel der genannten Gattung das Klemmteil ein um eine Drehachse manuell schwenkbarer Verriegelungsschwenkhebel ist, welcher einen aus der Oberfläche des Hebels herausragenden Keil aufweist, welcher beim Schwenken des Hebels in die Verriegelungsstellung, zum Beispiel im Uhrzeigersinn oder entgegengesetzten Sinn, im Wesentlichen tangential in die Aussparung des Anschlussstutzens des elektrischen Gerätes einzugreifen und welcher beim Schwenken in die Freigabestellung, zum Beispiel im Gegenuhrzeigersinn oder entgegengesetzten Sinn, aus der Aussparung herauszufahren imstande ist.

In weiterer erfindungsgemäßer Ausgestaltung des Befestigungssockels ist die Drehachse im Bereich des einen Endes des Verriegelungsschwenkhebels angeordnet, wobei sich der Keil mit abnehmender Höhe um die Drehachse herum dergestalt gekrümmt erstreckt, dass beim Schwenken des Hebels in die Verriegelungsstellung der Keil mit seiner geringsten Höhe in die Aussparung des Anschlussstutzens des elektrischen Gerätes einzutauchen beginnt, bis der Keil in der Endstellung der Verriegelungsstellung mit seiner vollen Höhe in der Aussparung aufgenommen ist.

Einer der Vorteile des erfindungsgemäßen Befestigungssockels besteht darin, dass derselbe es gestattet, mit einem einzigen Handgriff das innerhalb des Befestigungssockels gehalterte elektrische Gerät, wie elektrischer Sensor oder elektrischer Näherungsschalter, auszuwechseln, ohne dass hierfür weitere Hilfsmittel notwendig sind. Dadurch ist eine höchst einfache Montage und Handhabbarkeit des erfindungsgemäßen Befestigungssockels sowie des elektrischen Gerätes gegeben.

In einer weiteren erfindungsgemäßen Ausgestaltung des Befestigungssockels besteht der Keil aus einem längs der Längsachse des Keils gerade verlaufenden, Keilstück mit ebener Oberfläche und einem um die Drehachse herum gekrümmten Keilstück, welche ineinander übergehen, wobei sowohl das gerade Keilstück als auch das gekrümmte Keilstück in einer Ebene verlaufen, wobei das gerade Keilstück in Bezug auf die Drehachse tangential verläuft und beim Schwenken des Verriegelungsschwenkhebels in die Verriegelungsstellung das gerade Keilstück innerhalb der Aussparung des Anschlussstutzens des elektrischen Gerätes aufgenommen ist.

In einer weiteren erfindungsgemäßen Ausgestaltung des Befestigungssockels weist der Verriegelungsschwenkhebel an einem Ende einen Griff und am entgegengesetzten Ende einen Walzen- oder Zylinderkörper auf, welcher eine quer zur Längsachse des Verriegelungsschwenkhebels verlaufende Durchgangsbohrung zur Aufnahme der Drehachse besitzt, wobei der Keil zumindest teilweise tangential am Walzen- oder Zylinderkörper verlaufend im Bereich oberhalb der Drehachse an demselben angeordnet ist.

In weiterer erfindungsgemäßer Ausgestaltung des Befestigungssockels ist das gerade Keilstück des Keils zumindest teilweise tangential am Walzen- oder Zylinderkörper verlaufend im Bereich oberhalb der Drehachse an demselben angeordnet und erstreckt sich längs der Längsachse des Verriegelungsschwenkhebels, wobei das gekrümmte Keilstück aus der Oberfläche des Walzen- oder Zylinderkörpers radial hervorstehend um dieselbe teilweise herumläuft.

In weiterer erfindungsgemäßer Ausgestaltung des Befestigungssockels ist das gekrümmte Keilstück schräg verlaufend angeordnet, so dass in senkrechter Projektion auf das gerade Keilstück gesehen der Beginn des gekrümmten Keilstücks in direktem Anschluss an das gerade Keilstück und das Ende des gekrümmten Keilstücks gegenseitig um einen Abstand (s) versetzt sind. Insbesondere kann das gekrümmte Keilstück schräg, insbesondere ähnlich einer Schraubenlinie, um den Walzen- oder Zylinderkörper herum verlaufen. Auf diese Weise wird vorteilhaft erreicht, dass beim Schwenken des Verriegelungsschwenkhebels diese Schwenkbewegung, welche eine Drehbewegung ist, in eine Longitudinalbewegung des elektrischen Gerätes umgesetzt wird, so dass dasselbe weiter in die Aufnahmeöffnung innerhalb des Befestigungssockels hineingezogen und dort verklemmt wird.

In einer weiteren erfindungsgemäßen Ausgestaltung des Befestigungssockels weist derselbe zwei Wangen auf, welche je eine sich gegenüberliegende Lagerbohrung besitzen, durch welche die Drehachse des Verriegelungsschwenkhebels geführt ist, welcher zwischen den Wangen um die Drehachse schwenkbar angeordnet ist, wobei innerhalb des Befestigungssockels zwischen den Wangen im Bereich unterhalb der Drehachse der Befestigungssockel eine Aussparung zum Durchtritt des Keils peripher in die Aufnahmeöffnung aufweist. Dabei können sich die Wangen des Befestigungssockels in den beiden äußeren Oberflächen desselben erstrecken, welche von der Aufnahmeöffnung durchsetzt sind.

In einer weiteren erfindungsgemäßen Ausgestaltung des Befestigungssockels beträgt der Schwenkwinkel des Verriegelungsschwenkhebels um seine Drehachse ungefähr 180 Grad.

In weiterer erfindungsgemäßer Ausgestaltung des Befestigungssockels ist die Aussparung des Anschlussstutzens des elektrischen Gerätes, in welche in der Verriegelungsstellung der Keil des Verriegelungsschwenkhebels eintaucht, eine peripher den Anschlussstutzen umlaufende Nut. Es können sowohl die peripher den Anschlussstutzen umlaufende Nut als auch der Keil einen trapezförmigen Querschnitt aufweisen, wobei sich der Querschnitt der Nut nach unten zum Boden derselben und der Querschnitt des Keils nach oben zu seinem oberen Ende hin verjüngt. Auf diese Weise kann die Longitudinalbewegung des elektrischen Gerätes und die Klemmwirkung noch verstärkt werden.

Kurzbeschreibung der Zeichnung, in der zeigen:
Figur 1 eine perspektivische Ansicht eines Befestigungssockels mit einem Verriegelungsschwenkhebel, wobei derselbe in die Offenstellung geschwenkt ist;
Figur 2 eine perspektivische Ansicht des Befestigungssockels gemäß Figur 1, wobei hier der Verriegelungsschwenkhebel in einer Zwischenstellung vor der Schließstellung gezeigt ist;
Figur 3 eine persepektivische Ansicht des Befestigungssockels gemäß Figur 1, wobei hier der Verriegelungsschwenkhebel in der Schließstellung positioniert ist;
Figur 4 eine perspektivische Explosionszeichnung eines Sensors und des zugehörigen Befestigungssockels gemäß Figur 1 zur Aufnahme und Halterung des Sensors;
Figur 5 eine Seitenansicht des Verriegelungsschwenkhebels auf das stirnseitige, walzenförmige Ende desselben zur Darstellung des gekrümmten und in der Höhe abnehmenden Keilstücks und
Figur 6 eine perspektivische Ansicht des Verriegelungsschwenkhebels zur Darstellung der Ausgestaltung desselben und des Keils insgesamt.

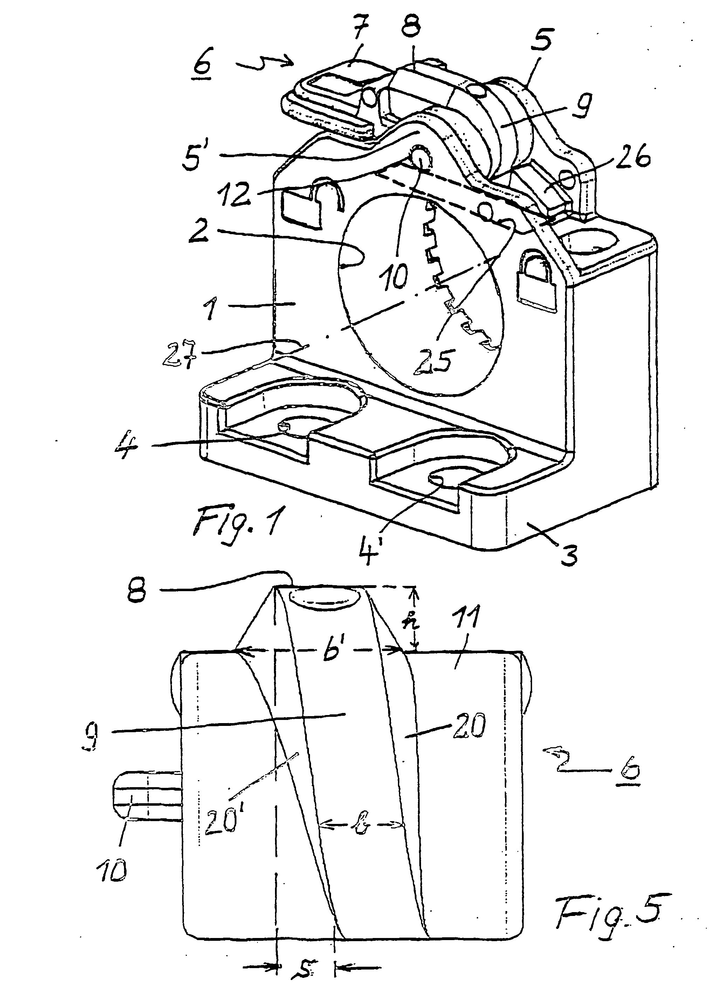

Gemäß den Figuren 1, 2 und 3 besitzt der Befestigungssockel 1 im Wesentlichen die Form eines Quaders mit zwei großen, sich gegenüberliegenden Hauptoberflächen, wobei am Befestigungssockel 1 ein Basisteil 3 zur Vergrößerung der Standfläche angeformt ist. Innerhalb des Basisteils 3 sind Durchgangslöcher 4,4' zur Aufnahme von Schrauben angeordnet, um den Befestigungssockel auf einen Untergrund festschrauben zu können. Der Befestigungssockel 1 weist eine Aufnahmeöffnung 2 auf, welche im gezeigten Beispiel durchgehend ist und welche dazu dient, ein in der Figur 4 gezeigtes Gehäuse 15 eines Sensors aufzunehmen, welcher ein Näherungsschalter, insbesondere ein induktiver Näherungsschalter, sein kann. Die Mittelachse 27 der Aufnahmeöffnung 2 ist im gezeigten Beispiel bezüglich des Befestigungssockels 1 waagrecht gerichtet, die Aufnahmeöffnung kann allerdings bezüglich des Befestigungssockels auch senkrecht gerichtet sein.

Der Befestigungssockel 1 weist an seinem oberen Ende zwei sich gegenüberliegende Wangen 5, 5' auf, welche sich in Fortsetzung der Deckflächen des Befestigungs-sockels 1 erstrecken und innerhalb derselben sich je eine Lagerbohrung 12 befindet, welche sich in den beiden Wangen 5, 5' gegenüberliegen. Zwischen den Wangen 5, 5' ist ein Verriegelungsschwenkhebel 6 angeordnet, welcher um eine Drehachse 10 um eines seiner Enden um beispielsweise 180° schwenkbar ist. Wie es den Figuren 1 bis 3 zu entnehmen ist, kann dabei der Verriegelungsschwenkhebel 6 von einer Offenstellung gemäß Figur 1 in eine Schließstellung gemäß Figur 3 geschwenkt werden.

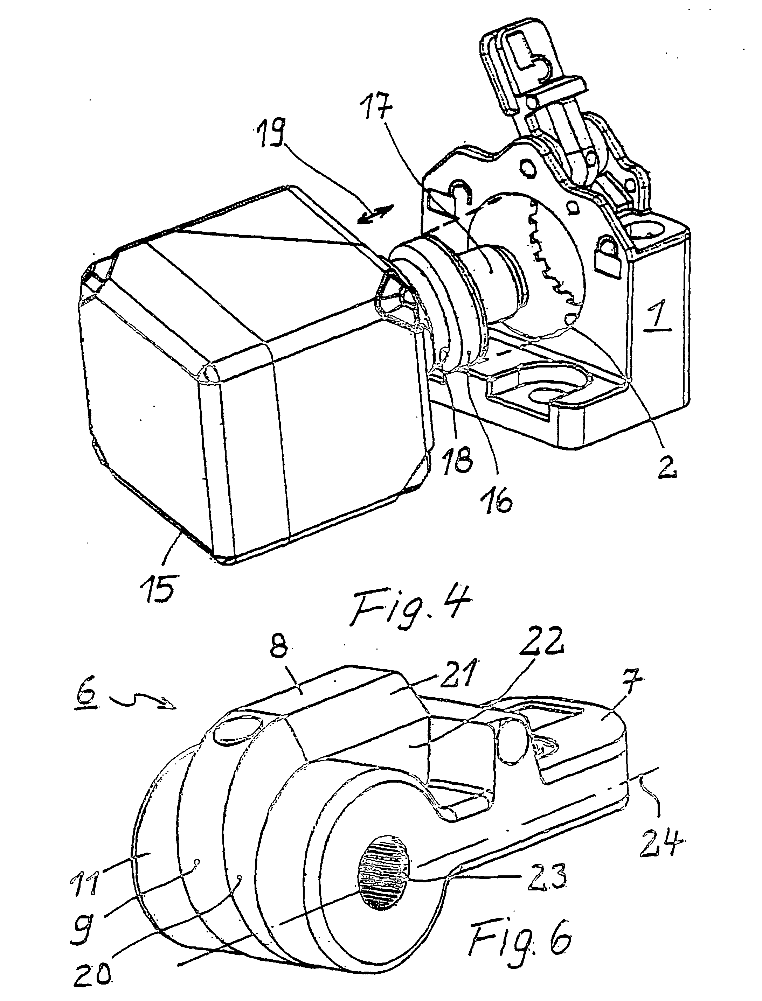

In den Figuren 5 und 6 ist der Verriegelungsschwenkhebel 6 näher dargestellt. Der länglich gestaltete Verriegelungsschwenkhebel 6 besteht im Wesentlichen aus einem Griff 7, welcher das eine, freibewegliche Ende des Verriegelungsschwenkhebels bildet und einem integral mit dem Griff 7 verbundenen Walzenkörper 11 oder einem zylinderförmigen Körper, welcher eine Durchgangsbohrung 23 zur Aufnahme der Drehachse 10 aufweist. Der Walzenkörper 11 bildet somit das drehseitige Ende des Verriegelungsschwenkhebels 6.

Längs der Längsachse 24 des Verriegelungsschwenkhebels ist auf dem Walzenkörper 11 ein Keil angeordnet, welcher die Höhe h aufweist und etwas über den Walzenkörper 11 in Richtung zum Griff 7 sowie über die Oberfläche des Walzenkörpers 11 um die Höhe h hinausragt. Dieser Keil setzt sich aus einem geraden Keilstück 8 und einem gekrümmten Keilstück 9 zusammen. Das gerade Keilstück 8, welches die Höhe h, gemessen von der Oberfläche des Walzenkörpers 11 aus, aufweist, erstreckt sich im Wesentlichen in Richtung der Längsachse 24 oberhalb der Durchgangsbohrung 23 bis über den Walzenkörper 11 hinweg. Dieses gerade Keilstück 8 wird längs durch zwei seitliche schräge Seitenwände 21 begrenzt, welche nach unten in Richtung zur Durchgangsbohrung 23 in je eine gerade Seitenwand 22 übergehen. Damit ist der Querschnitt des geraden Keils 8, welcher sich tangential an den Walzenkörper 11 anschließt, hinsichtlich seiner schrägen Seitenwände 21 und der oberen Deckfläche trapezförmig gestaltet, so dass das gerade Keilstück 8 im Wesentlichen die Form eines Trapezoeders besitzt. An dieses gerade Keilstück 8 schließt sich ein gekrümmtes Keilstück 9 an, welches um den Walzenkörper 8 herumläuft und in der Höhe abnehmend gestaltet ist, so dass die Höhe des gekrümmten Keilstücks 9 von der maximalen Höhe h im unmittelbaren Anschluss an das gerade Keilstück 8 bis Null umlaufend nach 180 ° auf der Oberfläche des Walzenkörpers 11 abnimmt. Damit ist das gerade Keilstück 8 des Keils zumindest teilweise tangential am Walzen- oder Zylinderkörper 11 verlaufend im Bereich oberhalb der Drehachse 10 an demselben angeordnet.

Des Weiteren verläuft im gezeigten Beispiel das gekrümmte Keilstück 9 schräg über die Oberfläche des Walzenkörpers 11, wie es der Figur 5 zu entnehmen ist. Somit liegt das untere Ende des gekrümmten Keilstücks 9 in der senkrechten Projektion um die Strecke s bezüglich des oberen, die Höhe h aufweisenden Endes des gekrümmten Keilstücks 9 versetzt. Das gekrümmte Keilstück 9 läuft somit aus der Oberfläche des Walzen- oder Zylinderkörpers 11 radial hervorstehend um dieselbe teilweise herum, wobei das gekrümmte Keilstück 9 insbesondere ähnlich einer Schraubenlinie um den Walzen- oder Zylinderkörper 11 herum verläuft.

Zum Durchtritt des Keils 8, 9 bei der Drehung des Verriegelungsschwenkhebels 6 in die Aufnahmeöffnung 2 des Befestigungssockels 1 und somit in die Verriegelungsstellung weist der Befestigungssockel 1 zwischen den Wangen 5, 5' im Bereich unterhalb der Drehachse 10 eine Aussparung 25 auf, welche in der Figur 1 gestrichelt angedeutet ist. Durch diese Aussparung 25 kann der Keil zuerst mit seinem gekrümmten Keilstück 9 und anschließend bei Weiterdrehung des Verriegelungsschwenkhebels 6 mit dem geraden Keilstück 8 peripher in die Aufnahmeöffnung eintreten. Seitlich an den Wangen 5, 5' sind zur Verbesserung der Führung des Keils bei seinem Durchtritt durch die Aussparung 25 innen Führungswangen 26 angeordnet.

Vorzugsweise beträgt der Schwenkwinkel des Verriegelungsschwenkhebels 6 um die Drehachse 10 ungefähr 180 Grad.

Die Figur 4 zeigt eine perspektivische Explosionszeichnung eines Gehäuses 15 eines Sensors und des zugehörigen Befestigungssockels 1 gemäß Figur 1 zur Aufnahme und Halterung des Gehäuses 15 des Sensors. Das Gehäuse 15 besitzt einen Befestigungsflansch 16, welcher einen Außendurchmesser gemäß dem Innendurchmesser der Aufnahmeöffnung 2 des Befestigungssockels 1 aufweist und welcher mit dem Befestigungsflansch 16 in Richtung der Mittelachse 27 in die Aufnahmeöffnung 2 gesteckt wird. Der Befestigungsflansch 16 weist als Aussparung, in welche in der Verriegelungsstellung der Keil des Verriegelungsschwenkhebels 6 eintaucht, eine Nut 18 auf, welche im gezeigten Beispiel peripher den Anschlussstutzen 16 umlaufend gestaltet ist. Diese Nut 18 besitzt einen entsprechenden Querschnitt wie das gerade Keilstück 9 des Keils, so dass dieser nach dem Einführen des Befestigungsflansches 16 in die Aufnahmeöffnung 2 passend in die Nut 18 eingreift.

In dem hier gezeigten Beispiel des Befestigungssockels 1 weisen sowohl die peripher den Anschlussstutzen 16 umlaufende Nut 18 als auch der Keil 8, 9 einen trapezförmigen Querschnitt auf, wobei sich der Querschnitt der Nut 18 nach unten zum Boden derselben und der Querschnitt des Keils 8, 9 nach oben zu seinem oberen Ende hin verjüngt.

Der Befestigungsflansch 16 weist an seinem vorderen Ende eine Aufnahmebuchs 18 auf, innerhalb derselben zum Beispiel sich eine elektrische Steckeraufnahme oder ein elektrischer Steckereinsatz befindet zum elektrischen Anschluss eines Gerätes.

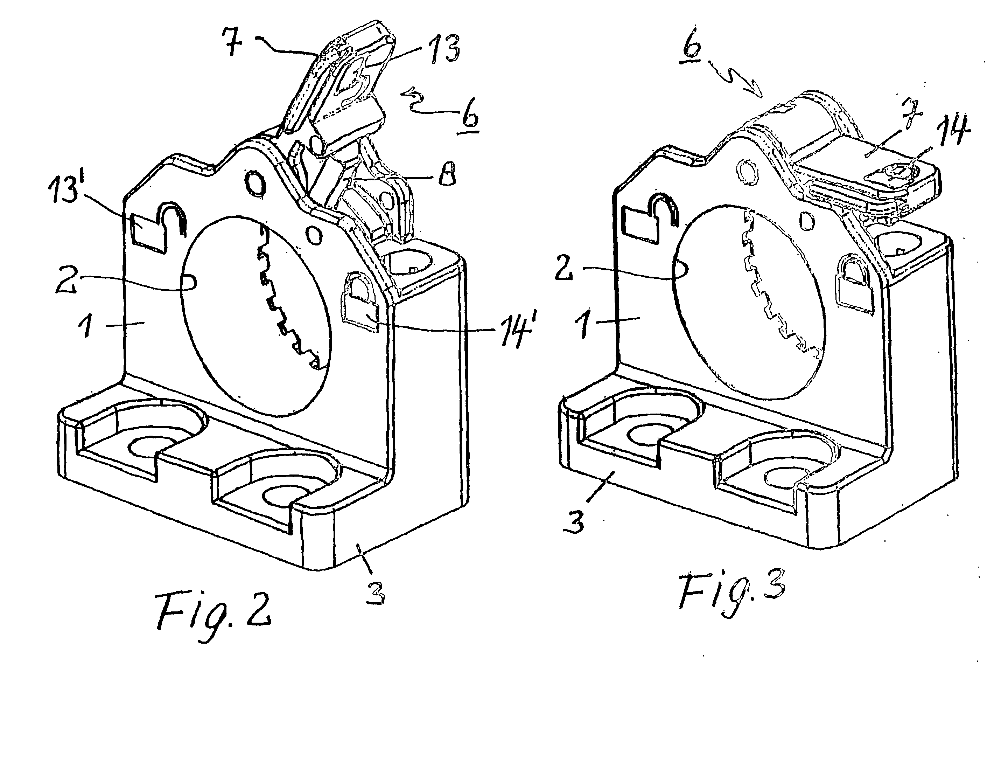

Zur Halterung des Gehäuses 15 wird dasselbe mit seinem Befestigungsflansch 16 in die Aufnahmeöffnung 2 des Befestigungssockels 1 eingeführt. Anschließend wird der Verriegelungsschwenkhebel 6 aus der Offenstellung, welche in Figur 1 gezeigt ist, in die Schließstellung der Figuren 2 und 3 geschwenkt. Dabei taucht zuerst das gekrümmte Keilstück 9 in die Nut 18 des Befestigungsflansches 16 ein. Bei Weiterdrehung zieht das Keilstück 9 aufgrund seiner schraubenlinienförmigen Kontur das Gehäuse 15 fest in den Befestigungssockel 1 hinein, bis das gerade Keilstück 8 in die Nut eintaucht. Auf diese Weise wird im gezeigten Beispiel die Drehbewegung des Verriegelungsschwenkhebels 6 in eine Longitudinalbewegung des Gehäuses 15 umgesetzt.

In einer vereinfachten Ausgestaltung kann der Keil auch vollständig in einer Ebene liegen, so dass eine zusätzliche Longitudinalbewegung des Gehäuses 15 beim Eintauchen des Keils in die Nut des Befestigungsflansches 16 nicht zu erfolgen braucht. Ebenso können der Querschnitt der Nut wie auch derjenige des Keils quadratisch oder rechteckförmig geformt sein.

### Liste der Bezugszeichen

- 1: Befestigungssockel
- 2: Aufnahmeöffnung
- 3: Basisteil
- 4,4': Durchgangslöcher für Schrauben
- 5,5': Wangen
- 6: Verriegelungsschwenkhebel
- 7: Griff
- 8: gerades Keilstück
- 9: gekrümmtes Keilstück
- 10: Drehachse
- 11: Walzenkörper
- 12: Lagerbohrung
- 13,13': Symbol für Offenstellung
- 14,14': Symbol für Geschlossenstellung
- 15: Elektrisches Bauelement, wie Sensor
- 16: Anschlussstutzen, wie Befestigungsflansch
- 17: elektrische Buchse, wie elektrische Aufnahmebuchse
- 18: Nut
- 19: Doppel-Bewegungspfeil
- 20,20': in der Höhe abnehmende Seitenwände des gekrümmten Keilstücks
- 21: schräge Seitenwand des geraden Keilstücks
- 22: gerade Seitenwand des geraden Keilstücks
- 23: Durchgangsbohrung
- 24: Längsachse des Verriegelungsschwenkhebels
- 25: Aussparung
- 26: Führungswange
- 27: Mittelachse der Aufnahmeöffnung

## Patentansprüche

1. Befestigungssockel (1) zum Haltern eines elektrischen Gerätes (15), mit einer Aufnahmeöffnung (2) zur Aufnahme eines Anschlussstutzens (16) des elektrischen Geräts (15) und mit einem Verriegelungsschwenkhebel (6) zum Fixieren des Anschlussstutzens (16) in der Aufnahmeöffnung (2), wobei der Verriegelungsschwenkhebel (6) in eine Verriegelungs- und eine Offenstellung verschwenkbar ist,
**dadurch gekennzeichnet,**
**dass** der Verriegelungsschwenkhebel (6) einen vorstehenden Keil (8, 9) aufweist und
**dass** der Keil (8, 9) zum wenigstens teilweise formschlüssigen Eingriff mit einer im Anschlussstutzen (16) vorgesehenen Aussparung (18) bei in Verriegelungsstellung geschwenktem Verriegelungsschwenkhebel (6) ausgebildet ist.

2. Befestigungssockel (1) zum Haltern eines elektrischen Gerätes (15) nach Anspruch 1,
mit einer Aufnahmeöffnung (2) des Befestigungssockels (1) zur Aufnahme eines am elektrischen Gerät (15) vorragenden, in die Aufnahmeöffnung passenden Anschlussstutzens (16), welcher eine peripher wenigstens teilweise umlaufende Aussparung (18) aufweist, wobei der Befestigungssockel (1) ein Klemmteil (6) besitzt, welches zum Haltern des Gerätes (15) innerhalb der Aufnahmeöffnung (2) in die Aussparung (18) des Anschlussstutzens (16) in eine Verriegelungsstellung absenkbar und zum Lösen desselben aus der Aussparung (18) des Anschlussstutzens (16) in eine Offenstellung hebbar angeordnet ist,
wobei das Klemmteil ein um eine Drehachse (10) manuell schwenkbarer Verriegelungsschwenkhebel (6) ist, welcher einen aus der Oberfläche des Hebels (6) herausragenden Keil (8,9) aufweist, welcher beim Schwenken des Hebels in die Verriegelungsstellung, zum Beispiel im Uhrzeigersinn oder entgegengesetzten Sinn, im Wesentlichen tangential in die Aussparung (18) des Anschlussstutzens (16) des elektrischen Gerätes (15) einzugreifen und welcher beim Schwenken in die Freigabestellung, zum Beispiel im Gegenuhrzeigersinn oder entgegengesetzten Sinn, aus der Aussparung (18) herauszufahren imstande ist.

3. Befestigungssockel nach Anspruch 1 oder 2,
**dadurch gekennzeichnet,**
**dass** die Drehachse (10) im Bereich des einen Endes des Verriegelungsschwenkhebels (6) angeordnet ist, wobei sich der Keil (8,9) mit abnehmender Höhe um die Drehachse herum dergestalt gekrümmt erstreckt, dass beim Schwenken des Hebels (6) in die Verriegelungsstellung der Keil (8,9) mit seiner geringsten Höhe in die Aussparung (18) des Anschlussstutzens (16) des elektrischen Gerätes (15) einzutauchen beginnt, bis der Keil (8,9) in der Endstellung der Verriegelungsstellung mit seiner vollen Höhe in der Aussparung (18) aufgenommen ist.

4. Befestigungssockel nach einem der Ansprüche 1 bis 3,
**dadurch gekennzeichnet,**
**dass** der Keil (8,9) aus einem längs der Längsachse (24) des Keils gerade verlaufenden, Keilstück (8) mit ebener Oberfläche und einem um die Drehachse (10) herum gekrümmten Keilstück (9) besteht, welche ineinander übergehen, wobei sowohl das gerade Keilstück (8) als auch das gekrümmte Keilstück (9) in einer Ebene verlaufen, wobei das gerade Keilstück (8) in Bezug auf die Drehachse (10) tangential verläuft und beim Schwenken des Verriegelungsschwenkhebels (6) in die verriegelungsstellung das gerade Keilstück (8) innerhalb der Aussparung (18) des Anschlussstutzens (16) des elektrischen Gerätes (15) aufgenommen ist.

5. Befestigungssockel nach einem der vorherigen Ansprüche,
**dadurch gekennzeichnet,**
**dass** der Verriegelungsschwenkhebel (6) an einem Ende einen Griff (7) und am entgegengesetzten Ende einen Walzen- oder Zylinderkörper (11) aufweist, welcher eine quer zur Längsachse (24) des Verriegelungsschwenkhebels (6) verlaufende Durchgangsbohrung (23) zur Aufnahme der Drehachse (10) besitzt, wobei der Keil (8,9) zumindest teilweise tangential am Walzen- oder Zylinderkörper (11) verlaufend im Bereich oberhalb der Drehachse (10) an demselben angeordnet ist.

6. Befestigungssockel nach einem der vorherigen Ansprüche,
**dadurch gekennzeichnet,**
**dass** das gerade Keilstück (8) des Keils zumindest teilweise tangential am Walzen- oder Zylinderkörper (11) verlaufend im Bereich oberhalb der Drehachse (10) an demselben angeordnet ist und sich längs der Längsachse (24) des Verriegelungsschwenkhebels (6) erstreckt, und das gekrümmte Keilstück (9) aus der Oberfläche des Walzen- oder Zylinderkörpers (11) radial hervorstehend um dieselbe teilweise herumläuft.

7. Befestigungssockel nach einem der vorherigen Ansprüche,
**dadurch gekennzeichnet,**
**dass** das gekrümmte Keilstück (9) schräg verlaufend angeordnet ist, so dass in senkrechter Projektion auf das gerade Keilstück (8) gesehen der Beginn des gekrümmten Keilstücks (9) in direktem Anschluss an das gerade Keilstück (8) und das Ende des gekrümmten Keilstücks (9) gegenseitig um einen Abstand (s) versetzt sind.

8. Befestigungssockel nach einem der Ansprüche 1 bis 7,
**dadurch gekennzeichnet,**
**dass** das gekrümmte Keilstück (9) schräg, insbesondere ähnlich einer Schraubenlinie, um den Walzen- oder Zylinderkörper (11) herum verläuft.

9. Befestigungssockel nach einem der Ansprüche 1 bis 8,
**dadurch gekennzeichnet,**
**dass** derselbe zwei Wangen (5,5') aufweist, welche je eine sich gegenüberliegende Lagerbohrung (12) besitzen, durch welche die Drehachse (10) des Verriegelungsschwenkhebels (6) geführt ist, welcher zwischen den Wangen (5,5') um die Drehachse (10) schwenkbar angeordnet ist, wobei innerhalb des Befestigungssockels (1) zwischen den Wangen (5,5') im Bereich unterhalb der Drehachse (10) der Befestigungssockel (1) eine Aussparung (25) zum Durchtritt des Keils (8,9) peripher in die Aufnahmeöffnung (2) aufweist.

10. Befestigungssockel nach Anspruch 9,
**dadurch gekennzeichnet,**
**dass** sich die Wangen (5,5') des Befestigungssockels (1) in den beiden äußeren Oberflächen desselben erstrecken, welche von der Aufnahmeöffnung (2) durchsetzt sind.

11. Befestigungssockel nach einem der vorherigen Ansprüche,
**dadurch gekennzeichnet,**
**dass** der Schwenkwinkel des Verriegelungsschwenkhebels (6) um die Drehachse (10) ungefähr 180 Grad beträgt.

12. Befestigungssockel nach einem der vorherigen Ansprüche,
**dadurch gekennzeichnet,**
**dass** die Aussparung des Anschlussstutzens (16) des elektrischen Gerätes (15), in welche in der Verriegelungsstellung der Keil (8,9) des Verriegelungsschwenkhebels (6) eintaucht, eine peripher den Anschlussstutzen (16) umlaufende Nut (18) ist.

13. Befestigungssockel nach Anspruch 12,
**dadurch gekennzeichnet,**
**dass** sowohl die peripher den Anschlussstutzen (16) umlaufende Nut (18) als auch der Keil (8,9) einen trapezförmigen Querschnitt aufweisen, wobei sich der Querschnitt der Nut (18) nach unten zum Boden derselben und der Querschnitt des Keils (8,9) nach oben zu seinem oberen Ende hin verjüngt.

## Claims

1. Fastening base (1) for mounting an electrical device (15), having a reception opening (2) for receiving a connecting piece (16) of the electrical device (15) and a locking pivot lever (6) for fixing the connecting piece (16) in the reception opening (2), the locking pivot lever (6) being pivotable into a locking position and an open position, **characterized in that** the locking pivot lever (6) has a projecting key (8, 9) and that the key (8, 9) is constructed for the at least partial positive engagement with a recess (18) in the connecting piece (16) when the locking pivot lever (6) is pivoted into the locking position.

2. Fastening base (1) for mounting an electrical device (15) according to claim 1,
having a reception opening (2) of the fastening base (1) for receiving a connecting piece (16) projecting from the electrical device (15) and fitting into the reception opening and which is provided with a peripheral, at least partly circumferential recess (18), the fastening base (1) having a clamping part (6), which for mounting the device (15) within the reception opening (2) can be lowered into the recess (18) of the connecting piece (16) in a locking position and for the release thereof from the recess (18) of the connecting piece (16) can be raised into an open position, the clamping part being a locking pivot lever (6) manually pivotable about a fulcrum (10) and which has a key (8, 9) projecting from the surface of the lever (6) and which on pivoting the lever into the locking position, e.g. clockwise or counterclockwise, engages substantially tangentially in the recess (18) of the connecting piece (16) of the electrical device (15) and which on pivoting into the release position, e.g. counterclockwise or clockwise, is able to move out of the recess (18).

3. Fastening base according to claim 1 or 2,
**characterized in that**
the fulcrum (10) is located in the vicinity of one end of the locking pivot lever (6), the key (8, 9) with decreasing height extends in curved manner about the fulcrum in such a way that on pivoting the lever (6) into the locking position the key (8, 9) with its minimum height starts to sink into the recess (18) of the connecting piece (16) of the electrical device (15) until the key (8, 9) has been received with its full height in the recess (18) at the end of the locking position.

4. Fastening base according to one of the claims 1 to 3,
**characterized in that**
the key (8, 9) comprises a key piece (8) with a planar surface running straight along the longitudinal axis (24) of the key and a key piece (9) curved about the fulcrum (10) and which pass into one another, both the straight key piece (8) and the curved key piece (9) running in a plane, the straight key piece (8) passing tangentially with respect to the rotation axis and on pivoting the locking pivot lever (6) into the locking position the straight key piece (8) is received within the recess (18) of the connecting piece (16) of the electrical device (15).

5. Fastening base according to one of the preceding claims,
**characterized in that**
the locking pivot lever (6) has at one end a grip (7) and at the opposite end a cylinder or roll body (11), which has a through bore (23) for receiving the fulcrum (10) and running transversely to the longitudinal axis (24) of the locking lever (6), the key (8, 9) being positioned at least partly tangentially on the cylinder or roll body (11) in the area above the fulcrum (10) thereon.

6. Fastening base according to one of the preceding claims,
**characterized in that**
the straight key piece (8) of the key is at least partly located tangentially on the cylinder or roll body (11) in the area above the fulcrum (10) thereon and extends along the longitudinal axis (24) of the locking pivot lever (6) and the curved key piece (9) projects radially out of the surface of the cylinder or roll body (11) and passes partially round the same.

7. Fastening base according to one of the preceding claims,
**characterized in that**
the curved key piece (9) slopes, so that in vertical projection on the straight key piece (8) the start of the curved key piece (9) connects directly to the straight key piece (8) and the end of the curved key piece (9) are mutually displaced by a distance (s).

8. Fastening base according to one of the claims 1 to 7,
**characterized in that**
the curved key piece (9) slopes, particularly similar to a helix, round the cylinder or roll body (11).

9. Fastening base according to one of the claims 1 to 8,
**characterized in that**
it has two sideplates (5, 5') having in each case a facing bearing bore (12) through which passes the fulcrum (10) of the locking pivot lever (6) pivotable about the fulcrum (10) between the sideplates (5, 5') and within the fastening base (1) between the sideplates (5, 5') in the area below the fulcrum (10) said fastening base (1) has a recess (25) for the passage of the key (8, 9) peripherally into the reception opening (2).

10. Fastening base according to claim 9,
**characterized in that**
the sideplates (5, 5') of the fastening base (1) extend in the two outer surfaces thereof which are traversed by the reception opening (2).

11. Fastening base according to one of the preceding claims,
**characterized in that**
the pivot angle of the locking pivot lever (6) about fulcrum (10) is approximately 180ø.

12. Fastening base according to one of the preceding claims,
**characterized in that**
the recess of the connecting piece (16) of the electrical device (15) in which the key (8, 9) of the locking pivot lever (6) is sunk in the locking position is a groove (18) passing peripherally round the connecting piece (16).

13. Fastening base according to claim 12,
**characterized in that**
both the groove (18) passing peripherally round the connecting piece (16) and the key (8, 9) have a trapezoidal cross-section, the cross-section of the groove (18) tapering downwards towards the bottom thereof and the cross-section of the key (8, 9) tapering upwards towards its upper end.

## Revendications

1. Socle de fixation (1) destiné à assurer le support d'un appareil électrique (15)
avec une ouverture de réception (2) destinée à recevoir un embout de raccordement (16) de l'appareil électrique (15) et avec un levier basculant de verrouillage (6) pour immobiliser l'embout de raccordement (16) dans l'ouverture de réception (2), le levier basculant de verrouillage (6) pouvant être pivoté dans une position de verrouillage et dans une position d'ouverture,
***caractérisé***
***en ce que*** le levier basculant de verrouillage (6) comprend une cale (8, 9) en saillie, et
***en ce que*** la cale (8, 9) est conformée pour une prise au moins partiellement par engagement positif avec un évidement (18) prévu dans l'embout de raccordement (16) quand le levier pivotant de verrouillage (6) est pivoté dans la position de verrouillage.

2. Socle de fixation (1) destiné à assurer le support d'un appareil électrique (15) selon la revendication 1,
avec une ouverture de réception (2) du socle de fixation (1) destinée à recevoir un embout de raccordement (16) formant saillie sur l'appareil électrique (15) et entrant dans l'ouverture de réception, embout qui présente un évidement (18) s'étendant au moins partiellement sur la périphérie, le socle de fixation (1) possédant un élément de blocage (6) qui, pour tenir l'appareil (15) dans l'ouverture de réception (2), peut être abaissé dans l'évidement (18) de l'embout de raccordement (16) dans une position de verrouillage et peut être levé dans une position ouverte hors de l'évidement (18) de l'embout de raccordement (16) pour libérer celui-ci,
l'élément de blocage étant un levier basculant de verrouillage (6) pouvant pivoter manuellement autour d'un axe de rotation (10), qui comprend une cale (8, 9) sortant de la surface du levier (6), cale qui, lors du pivotement du levier dans la position de verrouillage, par exemple dans le sens horaire ou dans le sens anti-horaire, est en mesure de s'engager pour l'essentiel tangentiellement dans l'évidement (18) de l'embout de raccordement (16) de l'appareil électrique (15) et qui, lors du pivotement vers la position de libération, par exemple dans le sens horaire ou dans le sens anti-horaire, est en mesure de sortir de l'évidement (18).

3. Socle de fixation selon la revendication 1 ou 2, ***caractérisé en ce que*** l'axe de rotation (10) est placé au niveau d'une première extrémité du levier basculant de verrouillage (6), la cale (8, 9) s'étendant de manière coudée autour de l'axe de rotation lorsque la hauteur diminue, de telle manière que, lors du pivotement du levier (6) dans la position de verrouillage, la cale (8, 9) commence à s'enfoncer avec sa plus faible hauteur dans l'évidement (18) de l'embout de verrouillage (16) de l'appareil électrique (15), jusqu'à ce que, dans la position finale de la position de verrouillage, la cale (8, 9) soit logée sur toute sa hauteur dans l'évidement (18).

4. Socle de fixation selon l'une quelconque des revendications 1 à 3, ***caractérisé en ce que*** la cale (8, 9) est composée d'une partie (8) de cale à surface plane s'étendant le long de l'axe longitudinal (24) de la cale et d'une partie (9) de cale courbée autour de l'axe de rotation (10), qui se raccordent l'une à l'autre, tant la partie de cale droite (8) que la partie de cale courbe (9) s'étendant dans un plan, la partie de cale droite (8) s'étendant tangentiellement à l'axe de rotation (10) et, lors du pivotement du levier basculant de verrouillage (6) dans la position de verrouillage, la partie de cale droite (8) étant logée dans le logement (18) de l'embout de raccordement (16) de l'appareil électrique (15).

5. Socle de fixation selon l'une quelconque des revendications précédentes, ***caractérisé en ce que*** le levier basculant de verrouillage (6) comprend, à une extrémité, une poignée (7) et, à l'extrémité opposée, un corps de rouleau ou de cylindre (11) qui possède un passage (23) s'étendant transversalement à l'axe longitudinal (24) du levier basculant de verrouillage (6) pour recevoir l'axe de rotation (10), la cale (8, 9) étant placée dans une zone au-dessus de l'axe de rotation (10), sur celui-ci et en s'étendant au moins partiellement de façon tangentielle au corps de rouleau ou de cylindre (11).

6. Socle de fixation selon l'une quelconque des revendications précédentes, ***caractérisé en ce que*** la partie de cale droite (8) de la cale est placée dans une zone au-dessus de l'axe de rotation (10), sur celui-ci et en s'étendant au moins partiellement de façon tangentielle au corps de rouleau ou de cylindre (11) et s'étend le long de l'axe longitudinal (24) du levier basculant de verrouillage (6), et la partie de cale courbe (9) sort de la surface du corps de rouleau ou de cylindre (11) en formant saillie radialement et en entourant partiellement celle-ci.

7. Socle de fixation selon l'une quelconque des revendications précédentes, ***caractérisé en ce que*** la partie de cale courbe (9) est disposée en biais, de telle sorte qu'en projection orthogonale sur la partie de cale droite (8), le début de la partie de cale courbe (9) directement à la suite de la partie de cale droite (8) et l'extrémité de la partie de cale courbe (9) sont décalées l'une de l'autre d'une distance (s).

8. Socle de fixation selon l'une quelconque des revendications 1 à 7, ***caractérisé en ce que*** la partie de cale courbe (9) s'étend à l'oblique, en particulier à la manière d'une vis, autour du corps de rouleau ou de cylindre (11).

9. Socle de fixation selon l'une quelconque des revendications 1 à 8, ***caractérisé en ce qu'***il présente deux joues (5, 5') qui possèdent chacune un perçage de palier (12) opposé à l'autre, à travers lesquels passe l'axe de rotation (10) du levier basculant de verrouillage (6), qui est placé pivotant autour de l'axe de rotation (10) entre les joues (5, 5'), le socle de fixation (1) présentant dans le socle de fixation (1) entre les joues (5, 5'), dans la zone au-dessous de l'axe de rotation (10), un évidement (25) pour le passage de la cale (8, 9) de manière périphérique dans l'ouverture de réception (2).

10. Socle de fixation selon la revendication 9, ***caractérisé en ce que*** les joues (5, 5') du socle de fixation (1) s'étendent dans les deux surfaces extérieures de celui-ci qui sont traversées par l'ouverture de réception (2).

11. Socle de fixation selon l'une quelconque des revendications précédentes, ***caractérisé en ce que*** l'angle de pivotement du levier basculant de verrouillage (6) autour de l'axe de rotation (10) est égal à environ 180 degrés.

12. Socle de fixation selon l'une quelconque des revendications précédentes, ***caractérisé en ce que*** l'évidement de l'embout de raccordement (16) de l'appareil électrique (15), dans lequel la cale (8, 9) du levier basculant de verrouillage (6) s'enfonce dans la position de verrouillage, est une rainure (18) entourant de façon périphérique l'embout de raccordement (16).

13. Socle de fixation selon la revendication 12, ***caractérisé en ce que*** tant la rainure (18) entourant de façon périphérique l'embout de raccordement (16) que la cale (8, 9) présentent une section trapézoïdale, la section de la rainure (18) s'effilant vers le bas en direction de son fond et la section de la cale (8, 9) s'effilant vers le haut en direction de son extrémité supérieure.
